# EUROPEAN PATENT APPLICATION

(11) **EP 4 611 042 A1**
(43) Date of publication of application: **03.09.2025**
(21) Application number: 23882241.5
(22) Date of filing: 31.08.2023
(51) Int. Cl.: H01L 27/146, H01L 23/02, H01L 31/02

(54) **PACKAGE AND METHOD FOR MANUFACTURING PACKAGE**

(30) Priority: 26.10.2022 JP 2022171105
(71) Applicant: Sony Semiconductor Solutions Corporation, Atsugi-shi, Kanagawa 243-0014 (JP)
(72) Inventor: HAMAGUCHI, Shingo, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/031763
(87) International publication number: WO 2024/090027

(57) **Abstract**

To improve stability at the time of mounting a cover while enabling removal of the cover of a package.

The package includes: a cover; a mounting portion to which the cover is mounted; a barrier metal layer provided between the cover and the mounting portion; a metal bonding layer formed on the barrier metal layer; and a solder layer that is bonded to the metal bonding layer and connects the cover and the mounting portion. The barrier metal layer may not interdiffuse with the solder layer. The barrier metal layer may be formed on the cover. The barrier metal layer may be formed on the substrate. The barrier metal layer may be formed on the semiconductor chip.

## Description

### TECHNICAL FIELD

The present technology relates to a package. Specifically, the present technology relates to a package from which a cover is removable and a method for manufacturing the package.

### BACKGROUND ART

In a package on which a solid-state imaging element is mounted, a transparent cover may be attached to the package in order to prevent dust from adhering to the solid-state imaging element. When the transparent cover is attached to the package, a flare may occur in a captured image due to a difference in refractive index between the transparent cover and the outside world. For this reason, the solid-state imaging element may be used in a state where the transparent cover is removed from the package. For example, in order to remove the transparent cover from the package, there has been proposed a configuration in which the adhesive force of the adhesive for bonding the transparent cover is set to such a strength that the transparent cover is not detached at the time of handling the imaging device and the transparent cover can be detached without being broken (see, for example, Patent Document 1).

### CITATION LIST

### PATENT DOCUMENT

Patent Document 1: Japanese Patent Application Laid-Open No. 11-355508

### SUMMARY OF THE INVENTION

### PROBLEMS TO BE SOLVED BY THE INVENTION

However, in the above-described conventional technique, if the adhesive force is set to such a strength that the transparent cover can be detached without destroying the transparent cover, the transparent cover may be detached at the time of handling the imaging device.

The present technology has been made in view of such a situation, and an object of the present technology is to improve stability at the time of mounting the cover while enabling removal of the cover of the package.

### SOLUTIONS TO PROBLEMS

The present technology has been made to solve the above-described problems, and a first aspect thereof is a package including: a cover; a mounting portion to which the cover is mounted; a barrier metal layer provided between the cover and the mounting portion; a metal bonding layer formed on the barrier metal layer; and a solder layer that is bonded to the metal bonding layer and connects the cover and the mounting portion. This brings about an effect that the metal of the metal bonding layer diffuses into the solder layer on the basis of the heat treatment of the package to which the cover is fixed via the solder layer, and the alloyed solder alloy layer reaches the barrier metal layer, so that the cover is peeled off from the mounting portion.

In addition, in the first aspect, the barrier metal layer may be formed on the cover. This brings about an effect that the cover is peeled off from the mounting portion with the barrier metal layer formed on the cover as a boundary.

In addition, in the first aspect, the barrier metal layer may be formed on the mounting portion. This brings about an effect that the cover is peeled off from the mounting portion with the barrier metal layer formed on the mounting portion as a boundary.

In addition, in the first aspect, a substrate on which the mounting portion is provided may be included, and the barrier metal layer may be formed on the substrate. This brings about an effect that the cover is peeled off from the substrate with the barrier metal layer formed on the substrate as a boundary.

In addition, in the first aspect, the cover may be insulated from the substrate. This brings about an effect that the cover is peeled off from the substrate without electrically affecting the substrate.

In addition, in the first aspect, a semiconductor chip mounted on the substrate may be provided. This brings about an effect that the semiconductor element is mounted on the package.

Furthermore, in the first aspect, the substrate may include a cavity in which the semiconductor chip is accommodated, and the mounting portion may be disposed around the cavity. This brings about an effect that the semiconductor chip is sealed.

Furthermore, in the first aspect, a light receiving element or a light emitting element may be formed on the semiconductor chip. This brings about an effect that the light receiving element or the light emitting element is mounted on the package.

In addition, in the first aspect, a semiconductor chip on which the mounting portion is provided may be included, and the barrier metal layer may be formed on the semiconductor chip. This brings about an effect that the cover is peeled off from the semiconductor chip with the barrier metal layer formed on the semiconductor chip as a boundary.

Further, in the first aspect, the cover may be insulated from the semiconductor chip. This brings about an effect that the semiconductor chip is peeled off from the substrate without electrically affecting the semiconductor chip.

Further, in the first aspect, a land electrode which is connected to the outside on the basis of solder connection and is different in material or film thickness from the metal bonding layer may be further included. This brings about an effect that the package is connected to the outside while making it possible to remove the cover.

In addition, in the first aspect, the cover may be transparent. This brings about an effect that the light receiving element or the light emitting element mounted on the package to which the cover is attached can be inspected.

Further, in the first aspect, the barrier metal layer may not interdiffuse with the solder layer. This brings about an effect of preventing bonding between the barrier metal layer and the solder layer.

In addition, in the first aspect, the metal bonding layer may have a film thickness of 1 µm or less. This brings about an effect that the heat treatment condition for allowing the solder alloy layer alloyed by diffusion of the metal contained in the metal bonding layer into the solder layer to reach the barrier metal layer is relaxed.

In addition, in the first aspect, an area of the metal bonding layer may be smaller than a connection area on an opposite side of the solder layer bonded to the metal bonding layer. This brings about an effect that the solder alloy layer is easily peeled off from the barrier metal layer.

Furthermore, a second aspect of the present technology is a method for manufacturing a package, the method including: a step of causing a solder alloy layer in which a metal included in a metal bonding layer and a solder layer are alloyed to reach a barrier metal layer by heat-treating the package in which a cover is mounted on a mounting portion via the solder layer bonded to the metal bonding layer formed on the barrier metal layer; and a step of peeling the cover from the mounting portion at a boundary between the solder alloy layer and the barrier metal layer. This brings about an effect that the cover is peeled off from the mounting portion on the basis of the heat treatment of the package to which the cover is fixed via the solder layer.

In addition, in the second aspect, the barrier metal layer may be formed on the cover. This brings about an effect that the cover is peeled off from the mounting portion with the barrier metal layer formed on the cover as a boundary.

In addition, in the second aspect, the barrier metal layer may be formed on the mounting portion. This brings about an effect that the cover is peeled off from the mounting portion with the barrier metal layer formed on the mounting portion as a boundary.

In addition, in the second aspect, the mounting portion may be provided on a substrate, and the barrier metal layer may be formed on the substrate. This brings about an effect that the cover is peeled off from the substrate with the barrier metal layer formed on the substrate as a boundary.

Furthermore, in the second aspect, the mounting portion may be provided on a semiconductor chip, and the barrier metal layer may be formed on the semiconductor chip. This brings about an effect that the cover is peeled off from the semiconductor chip with the barrier metal layer formed on the semiconductor chip as a boundary.

### BRIEF DESCRIPTION OF DRAWINGS

Fig. 1 is a cross-sectional view illustrating a configuration example of a package according to a first embodiment.
Fig. 2 is a cross-sectional view illustrating an example of a cover removal process according to the first embodiment.
Fig. 3 is a cross-sectional view illustrating a configuration example of a package according to a second embodiment.
Fig. 4 is a cross-sectional view illustrating a configuration example of a package according to a third embodiment.
Fig. 5 is a cross-sectional view illustrating an example of a cover removal process according to the third embodiment.
Fig. 6 is a cross-sectional view illustrating a configuration example of a package according to a fourth embodiment.
Fig. 7 is a cross-sectional view illustrating a configuration example of a package according to a fifth embodiment.
Fig. 8 is a cross-sectional view illustrating an example of a cover removal process according to the sixth embodiment.
Fig. 9 is a cross-sectional view illustrating a configuration example of a package according to a sixth embodiment.
Fig. 10 is a plan view illustrating a configuration example of a cover according to a seventh embodiment.
Fig. 11 is a block diagram depicting an example of schematic configuration of a vehicle control system
Fig. 12 is a diagram of assistance in explaining an example of installation positions of an imaging section.

### MODE FOR CARRYING OUT THE INVENTION

Modes for carrying out the present technology (hereinafter, referred to as embodiments) will be described below. The description will be given in the following order.
1. First Embodiment (Example of Being Removed at Boundary Between Barrier Metal Layer and Solder Alloy Layer Formed on Cover)
2. Second Embodiment (Example in Which Cover Is Removed at Boundary Between Barrier Metal Layer and Solder Alloy Layer Formed on Cover Provided With Cavity)
3. Third Embodiment (Example in Which Cover Is Removed at Boundary Between Barrier Metal Layer and Solder Alloy Layer Formed on Substrate)
4. Fourth Embodiment (Example in Which Cover Is Removed at Boundary Between Barrier Metal Layer and Solder Alloy Layer Formed on Frame Member Indicating Cover)
5. Fifth Embodiment (Example in Which Cover Is Removed at Boundary Between Barrier Metal Layer and Solder Alloy Layer Formed on Face-Up Mounted Semiconductor Chip)
6. Sixth Embodiment (Example in Which Cover Is Removed at Boundary Between Barrier Metal Layer and Solder Alloy Layer Formed on Face-Down Mounted Semiconductor Chip)
7. Seventh Embodiment (Example of Planar Pattern of Barrier Metal Layer and Solder Alloy Layer Formed on Cover)
8. Application Example to Mobile Body

### <1. First Embodiment>

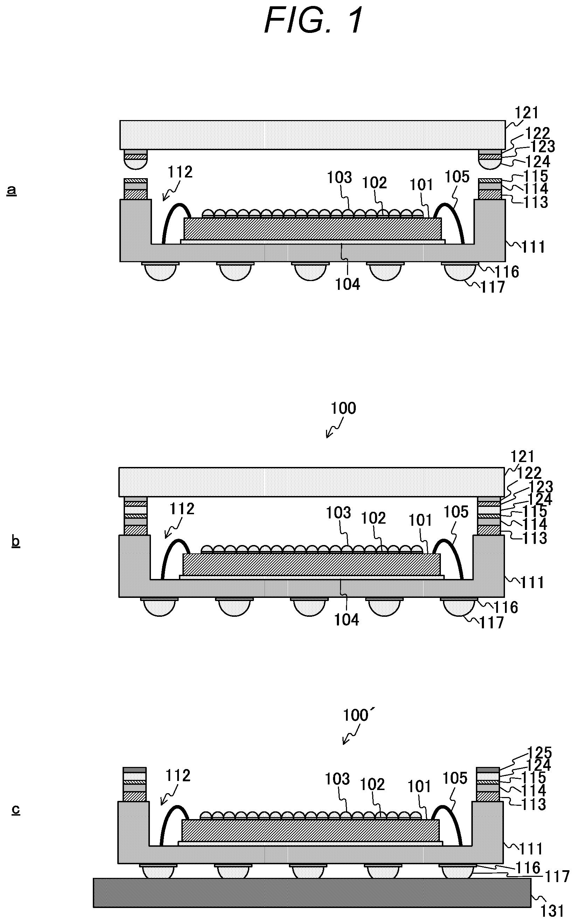

Fig. 1 is a cross-sectional view illustrating a configuration example of a package according to a first embodiment. Note that a in the drawing is a cross-sectional view illustrating a schematic configuration example of a substrate 111 before a cover 121 is attached. b in the drawing is a cross-sectional view illustrating a schematic configuration example of a package 100 in which the cover 121 is attached to the substrate 111. c in the drawing is a cross-sectional view illustrating a mounting example of a package 100' from which the cover 121 is removed. Note that, in the drawings used in the following description, a scale, a shape, and the like may be different from an actual structure in order to facilitate understanding of each configuration.

In the drawing, the package 100 includes a semiconductor chip 101, the substrate 111, and the cover 121.

A cavity 112 capable of housing the semiconductor chip 101 is formed in the substrate 111. A bump electrode 117 is formed on the back surface of the substrate 111 via a land electrode 116. The bump electrode 117 may be a solder ball or a pillar electrode. Wiring and bonding pads may be formed on the substrate 111. The base material of the substrate 111 may be ceramic, glass, or resin. Note that the substrate 111 is an example of a mounting portion described in the claims.

The semiconductor chip 101 is face-up mounted in the cavity 112. At this time, the semiconductor chip 101 is die-bonded into the cavity 112 via a die-bonding material 104. The die-bonding material 104 may be an adhesive, a paste material mixed with a metal such as Ag, or a solder material.

In the semiconductor chip 101, an optical element such as a light receiving element or a light emitting element may be formed, or a semiconductor element such as a transistor or a diode may be formed. The optical element or semiconductor element may be integrated. The optical element may be a solid-state imaging element such as a charged coupled device (CCD) or a complementary metal-oxide semiconductor (CMOS). The solid-state imaging element may be a back-illuminated solid-state imaging element. The light received by the solid-state imaging element may be visible light, near infrared light (NIR), short wavelength infrared light (SWIR), ultraviolet light, X-ray, or the like. The optical element may be a light receiving element such as a photo diode (PD), or may be a light emitting element such as a laser diode (LD), a light emitting diode (LED), or a vertical cavity surface emitting laser (VCSEL). The optical element may be a micro electro mechanical systems (MEMS) element such as an optical switch or a mirror device.

In the semiconductor chip 101, a semiconductor memory such as a static random access memory (SRAM) or a dynamic random access memory (DRAM) may be formed. In addition, a processor such as a central processing unit (CPU) or a graphics processing unit (GPU) may be formed in the semiconductor chip 101. In addition, a hardware circuit such as a field-programmable gate array (FPGA) or an application specific integrated circuit (ASIC) may be formed in the semiconductor chip 101. In the semiconductor chip 101, a signal processing circuit may be formed, a data processing circuit may be formed, an interface circuit may be formed, or an optical element may be formed. As a material of the semiconductor substrate used for the semiconductor chip 101, a semiconductor such as Si, SiC, GaN, GaAs, InP, InGaAs, or InGaAsP can be used.

In the following description, a case where the semiconductor chip 101 is a sensor chip including a solid-state imaging element is taken as an example. At this time, the semiconductor chip 101 may include, for example, an image signal processor (ISP) or a dynamic random access memory (DRAM). The sensor chip is provided with a pixel region in which pixels are arranged in a matrix in a row direction and a column direction.

At this time, an on-chip lens 103 may be formed on the semiconductor chip 101 via a color filter 102 for each pixel. The color filters 102 may constitute a Bayer array. A transparent resin such as acrylic or polycarbonate may be used as the material of the color filter 102 and the on-chip lens 103. A colorant such as a pigment may be mixed in the color filter 102.

The semiconductor chip 101 is electrically connected to the substrate 111 via a bonding wire 105. The material of the bonding wire 105 may be a metal such as Au or Al.

On the substrate 111, the cover 121 is disposed so as to be located on the semiconductor chip 101. The cover 121 can be fixed to the substrate 111 via a solder layer 124. At this time, the cover 121 may be insulated from the substrate 111. The cover 121 may be a transparent substrate. The material of the transparent substrate may be glass, quartz, or a transparent resin such as acrylic or polycarbonate.

The cover 121 protects the semiconductor chip 101 mounted on the substrate 111. At this time, the cover 121 can prevent foreign matter such as dust and dirt from entering the cavity 112 of the substrate 111, and can improve the handling property of the package 100. The planar size of the cover 121 may be equal to the planar size of the substrate 111.

A metal bonding layer 123 is formed on the cover 121 with a barrier metal layer 122 interposed therebetween. The barrier metal layer 122 and the metal bonding layer 123 may be formed in a line shape or a dot shape along the outer periphery of the cover 121. The material of the barrier metal layer 122 can be a metal that allows the metal bonding layer 123 to be plated on the barrier metal layer 122 and does not interdiffuse with the solder layer 124. The material of the barrier metal layer 122 may be, for example, a metal such as Ti, Ta, or W, or may have a laminated structure of two or more of these metals. The metal bonding layer 123 can be bonded to the solder layer 124. Metal that can interdiffuse with the solder layer 124 can be used as the material of the metal bonding layer 123. The material of the metal bonding layer 123 may be, for example, Cu, Ni, Au, or the like, or may have a laminated structure of two or more of these metals. The material of the solder layer 124 may contain, for example, Sn as a main component. The thickness of the metal bonding layer 123 is preferably 1 µm or less. As a result, the metal bonding layer 123 can be easily eliminated on the basis of alloying with the solder layer 124, and the heat treatment conditions necessary for removing the cover 121 can be relaxed. In addition, the area of the metal bonding layer 123 may be smaller than the connection area on the opposite side of the solder layer 124 bonded to the metal bonding layer 123. At this time, the contact area between the metal bonding layer 123 and the barrier metal layer 122 can be reduced. As a result, the force at the time of peeling the cover 121 can be concentrated on the boundary surface with the barrier metal layer 122, and peeling of the cover 121 can be facilitated.

On the substrate 111, a three-layer structure of a base layer 113, an intermediate layer 114, and a surface layer 115 is formed so as to be located outside the cavity 112. At this time, the base layer 113 is disposed at a position facing the metal bonding layer 123. The three-layer structure of the base layer 113, the intermediate layer 114, and the surface layer 115 can be bonded to the solder layer 124. As the materials of the base layer 113, the intermediate layer 114, and the surface layer 115, a metal capable of interdiffusing with the solder layer 124 can be used. The base layer 113 can ensure adhesion with the substrate 111. The material of the base layer 113 can be, for example, Cu. The intermediate layer 114 can ensure heat resistance. The material of the intermediate layer 114 can be, for example, Ni. The surface layer 115 can ensure wettability of the solder layer 124. The material of the surface layer 115 can be, for example, Au.

As illustrated in b of the drawing, the metal bonding layer 123 and the surface layer 115 are connected via the solder layer 124, whereby the package 100 in which the cover 121 is mounted on the substrate 111 is manufactured. Reflow, seam welding, or laser welding can be used for the connection using the solder layer 124. At this time, before the cover 121 is mounted on the substrate 111, the solder layer 124 may be formed on the metal bonding layer 123, or the solder layer 124 may be formed on the surface layer 115, as illustrated in a of the drawing. Here, when the metal bonding layer 123 and the surface layer 115 are connected via the solder layer 124, a flux may be used for the solder layer 124. This makes it possible to melt the solder layer 124 while preventing the bump electrode 117 from being melted at the time of solder reflow.

As illustrated in c of the drawing, the package 100 in which the cover 121 is mounted on the substrate 111 is mounted on the mother board 131 via the bump electrode 117. In the package 100 mounted on the mother board 131, the semiconductor chip 101 can be inspected. At this time, the semiconductor chip 101 may be inspected while the cover 121 is attached. The cover 121 can be removed when the mother board 131 on which the package 100 is mounted is incorporated into a product such as a camera.

At this time, the heat treatment of the solder layer 124 is performed to diffuse the metal included in the metal bonding layer 123 into the solder layer 124, thereby generating a solder alloy layer 125 in which the metal included in the metal bonding layer 123 and the solder layer 124 are alloyed. Here, the heat treatment time or the heat treatment temperature is adjusted to allow the solder alloy layer 125 to reach the barrier metal layer 122. The heat treatment temperature can be set to a temperature at which the bump electrode 117 does not melt. When the solder alloy layer 125 reaches the barrier metal layer 122, the solder alloy layer 125 can be easily peeled off from the barrier metal layer 122. Therefore, the cover 121 can be removed from the substrate 111 at the boundary between the solder alloy layer 125 and the barrier metal layer 122. At this time, the package 100' from which the cover 121 is removed is formed on the mother board 131.

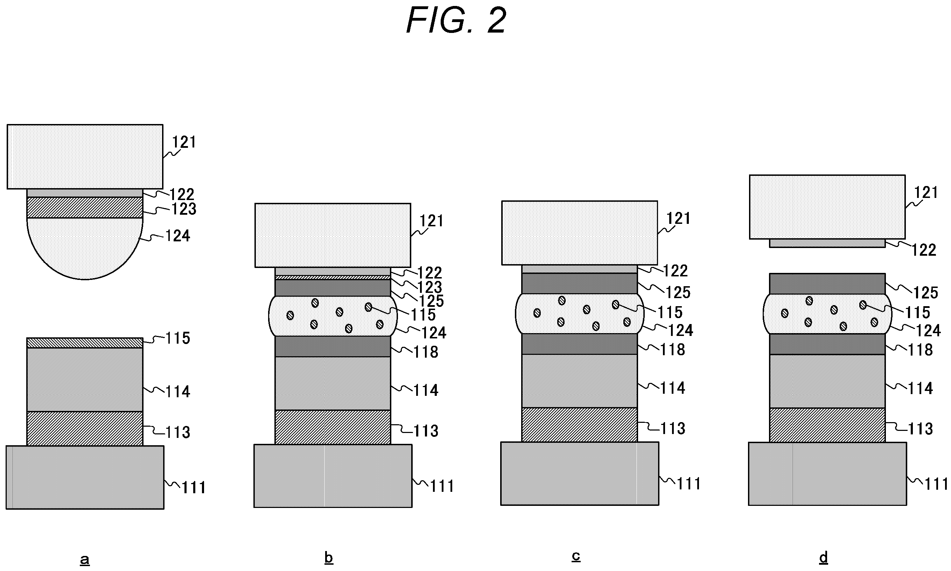

Fig. 2 is a cross-sectional view illustrating an example of the cover removal process according to the first embodiment. Note that, a in the drawing is a cross-sectional view illustrating an example of a state of the barrier metal layer 122 and the metal bonding layer 123 before the cover 121 is attached. b in the drawing is a cross-sectional view illustrating an example of a state of the barrier metal layer 122, the metal bonding layer 123, and the solder alloy layer 125 after the cover 121 is attached. c in the drawing is a cross-sectional view illustrating an example of a state in which the solder alloy layer 125 reaches the barrier metal layer 122 after the cover 121 is attached. d in the drawing is a cross-sectional view illustrating an example of a state of the barrier metal layer 122 and the solder alloy layer 125 after the cover 121 is removed.

In a of the drawing, the solder layer 124 is formed on the metal bonding layer 123. The cover 121 provided with the solder layer 124 is positioned such that the solder layer 124 and the surface layer 115 face each other.

Next, as illustrated in b of the drawing, the solder layer 124 provided on the cover 121 is bonded to the surface layer 115 on the basis of the heat treatment. At this time, the surface layer 115 diffuses into the solder layer 124, and a solder alloy layer 118 in which the intermediate layer 114 and the solder layer 124 are alloyed is generated in a part of the intermediate layer 114. For example, in a case where the material of the solder layer 124 is Sn and the material of the intermediate layer 114 is Ni, an inter metallic compound (IMC) of Sn and Ni is formed as the solder alloy layer 118. In addition, the metal included in the metal bonding layer 123 diffuses into the solder layer 124, and the solder alloy layer 125 in which the metal included in the metal bonding layer 123 and the solder layer 124 are alloyed is generated. For example, in a case where the material of the solder layer 124 is Sn and the material of the metal bonding layer 123 is Cu, IMC of Sn and Cu is formed as the solder alloy layer 125.

As illustrated in c of the drawing, the solder alloy layer 125 reaches the barrier metal layer 122 as the heat treatment proceeds, and can be peeled off from the barrier metal layer 122. Therefore, as illustrated in d in the drawing, the cover 121 can be removed from the substrate 111 at the boundary between the solder alloy layer 125 and the barrier metal layer 122.

As described above, in the first embodiment, the metal bonding layer 123 is formed on the cover 121 via the barrier metal layer 122. Then, the solder alloy layer 125 obtained by alloying the solder layer 124 connecting the cover 121 and the substrate 111 with the metal bonding layer 123 reaches the barrier metal layer 122. As a result, the solder alloy layer 125 can be peeled off from the barrier metal layer 122, and the bonding force between the metal bonding layer 123 and the barrier metal layer 122 can be eliminated. Therefore, the cover 121 can be easily removed from the substrate 111 while the mountability of the cover 121 to the substrate 111 is stabilized. As a result, it is possible to prevent flare and light attenuation after the package 100 is incorporated while preventing the cover 121 from being detached at the time of handling the package 100.

### <2. Second Embodiment>

In the first embodiment described above, the cavity 112 that separates the semiconductor chip 101 mounted on the substrate 111 from the cover 121 is provided in the substrate 111. In a second embodiment, a cavity for separating the semiconductor chip 101 mounted on the substrate from the cover 121 is provided in the cover.

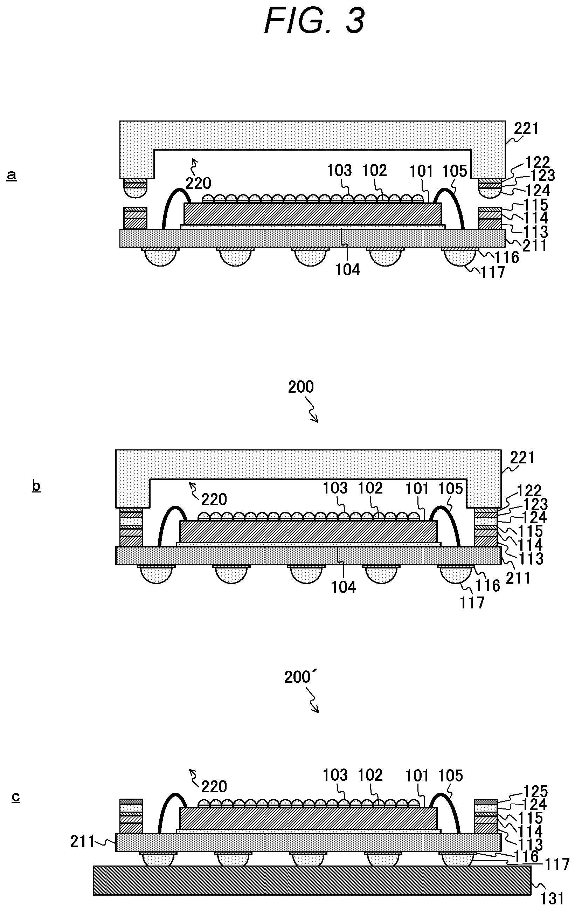

Fig. 3 is a cross-sectional view illustrating a configuration example of a package according to the second embodiment. Note that a in the drawing is a cross-sectional view illustrating a schematic configuration example of a substrate 211 before a cover 221 is attached. b in the drawing is a cross-sectional view illustrating a schematic configuration example of a package 200 in which the cover 221 is attached to the substrate 211. c in the drawing is a cross-sectional view illustrating a mounting example of a package 200' from which the cover 221 is removed.

In the drawing, the package 200 includes the substrate 211 and the cover 221 instead of the substrate 111 and the cover 121 of the first embodiment described above. Other configurations of the package 200 of the second embodiment are similar to those of the package 100 of the first embodiment described above.

The substrate 211 can be formed in, for example, a flat plate shape. The bump electrode 117 is formed on the back surface of the substrate 211 via the land electrode 116. Wiring and bonding pads may be formed on the substrate 211. The semiconductor chip 101 is face-up mounted on the substrate 211 via the die-bonding material 104. Note that the substrate 211 is an example of a mounting portion described in the claims.

The cover 221 protects the semiconductor chip 101 mounted on the substrate 211. A cavity 220 capable of housing the semiconductor chip 101 is formed in the cover 221. The cover 221 is disposed on the substrate 211 so as to be located on the semiconductor chip 101. At this time, the cover 221 can be fixed to the substrate 211 via the solder layer 124. The planar size of the cover 221 may be equal to the planar size of the substrate 211.

The metal bonding layer 123 is formed on the cover 221 with the barrier metal layer 122 interposed therebetween. The barrier metal layer 122 and the metal bonding layer 123 may be formed in a line shape or a dot shape along the outer periphery of the cover 221.

On the substrate 211, a three-layer structure of the base layer 113, the intermediate layer 114, and the surface layer 115 is formed so as to be located outside the bonding region. At this time, the surface layer 115 is disposed at a position capable of facing the metal bonding layer 123.

Then, as illustrated in b of the drawing, the metal bonding layer 123 and the surface layer 115 are connected via the solder layer 124, whereby the package 200 in which the cover 221 is mounted on the substrate 211 is manufactured. At this time, before the cover 221 is mounted on the substrate 211, the solder layer 124 may be formed on the metal bonding layer 123, or the solder layer 124 may be formed on the surface layer 115, as illustrated in a of the drawing.

As illustrated in c of the drawing, the package 200 in which the cover 221 is mounted on the substrate 211 is mounted on the mother board 131 via the bump electrode 117. Then, when the mother board 131 on which the package 200 is mounted is incorporated into a product such as a camera, the cover 221 can be removed. When the cover 221 is removed, the solder alloy layer 125 in which the metal included in the metal bonding layer 123 and the solder layer 124 are alloyed is generated. At this time, by allowing the solder alloy layer 125 to reach the barrier metal layer 122, the solder alloy layer 125 can be easily peeled off from the barrier metal layer 122. Therefore, the cover 221 can be removed from the substrate 211 at the boundary between the solder alloy layer 125 and the barrier metal layer 122. At this time, the package 200' from which the cover 221 is removed is formed on the mother board 131.

As described above, in the second embodiment described above, the cavity 220 that separates the semiconductor chip 101 mounted on the substrate 211 from the cover 221 is provided in the cover 221. As a result, it is possible to stabilize the mountability of the cover 221 on the substrate 211 while simplifying the configuration of the substrate 211, and it is possible to easily remove the cover 221 from the substrate 211.

### <3. Third Embodiment>

In the first embodiment described above, the barrier metal layer 122 and the metal bonding layer 123 are formed on the cover 121. In a third embodiment, a barrier metal layer and a metal bonding layer are formed on the substrate 111.

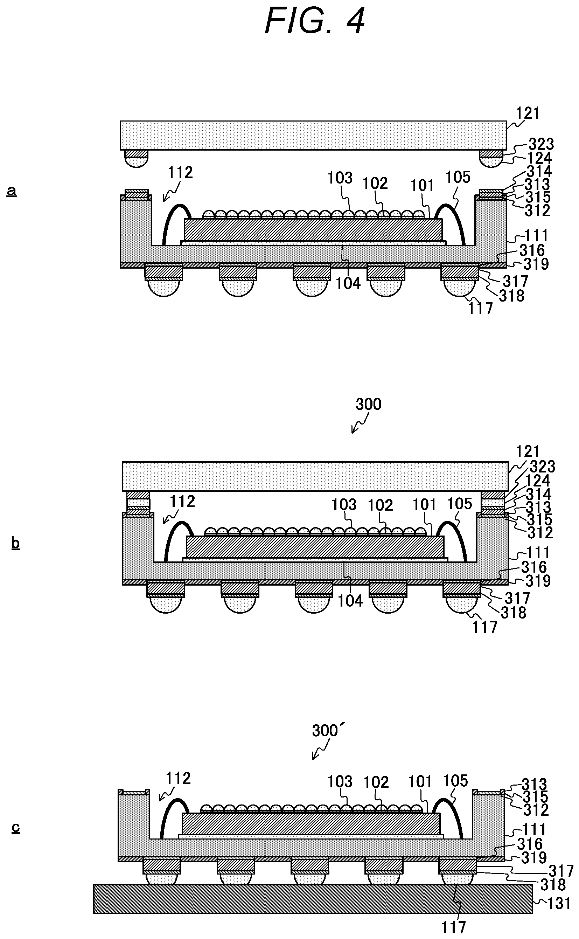

Fig. 4 is a cross-sectional view illustrating a configuration example of a package according to the third embodiment. Note that a in the drawing is a cross-sectional view illustrating a schematic configuration example of a substrate 111 before a cover 121 is attached. b in the drawing is a cross-sectional view illustrating a schematic configuration example of a package 300 in which the cover 121 is attached to the substrate 111. c in the drawing is a cross-sectional view illustrating a mounting example of a package 300' from which the cover 121 is removed.

In the drawing, the package 300 includes a barrier metal layer 312, metal bonding layers 313 and 323, and a surface layer 314 in place of the barrier metal layer 122, the metal bonding layer 123, the base layer 113, the intermediate layer 114, and the surface layer 115 of the first embodiment described above. In addition, the package 300 has a three-layer structure of a barrier metal layer 316, a metal bonding layer 317, and a surface layer 318 as the land electrode 116 of the first embodiment described above. Other configurations of the package 300 of the third embodiment are similar to those of the package 100 of the first embodiment described above.

On the back surface of the substrate 111, a three-layer structure of the barrier metal layer 316, the metal bonding layer 317, and the surface layer 318 is formed in a land shape. The bump electrode 117 is formed on the surface layer 318. The metal bonding layer 317 can be bonded to a solder material. The thickness of the metal bonding layer 317 can be set so that the solder alloy layer in which the metal bonding layer 317 is alloyed with the solder material does not reach the barrier metal layer 316 during solder reflow. Accordingly, even in a case where the bump electrode 117 melts during solder reflow, connection between the bump electrode 117 and the substrate 111 can be maintained. The material of the barrier metal layer 316 can be a metal that allows the metal bonding layer 317 to be plated on the barrier metal layer 316 and does not interdiffuse with the solder material. The material of the metal bonding layer 317 may be, for example, Cu, Ni, or the like. The material of the barrier metal layer 316 may be, for example, a metal such as Ti, Ta, or W, or may have a laminated structure of two or more of these metals. The surface layer 318 can ensure wettability of the solder material. The material of the surface layer 318 can be, for example, Au. The three-layer structure of the barrier metal layer 316, the metal bonding layer 317, and the surface layer 318 is an example of a land electrode described in the claims.

In addition, on the back surface of the substrate 111, an insulating layer 319 is formed so as to cover the periphery of the barrier metal layer 316. The material of the insulating layer 319 can be, for example, aluminum oxide.

The metal bonding layer 313 is formed on the substrate 111 with the barrier metal layer 312 interposed therebetween. The surface layer 314 is formed on the metal bonding layer 313. The barrier metal layer 312, the metal bonding layer 313, and the surface layer 314 can be disposed outside the cavity 112. At this time, the surface layer 314 is disposed at a position facing the metal bonding layer 323. The surface layer 314 can be bonded to the solder layer 124. The material of the barrier metal layer 312 can be a metal that allows the metal bonding layer 313 to be plated on the barrier metal layer 312 and does not interdiffuse with the solder layer 124. The material of the barrier metal layer 312 may be, for example, a metal such as Ti, Ta, or W, or may have a laminated structure of two or more of these metals. The material and film thickness of the barrier metal layer 312 may be the same as the material and film thickness of the barrier metal layer 316. Metal that can interdiffuse with the solder layer 124 can be used as the material of the metal bonding layer 313. The material of the metal bonding layer 313 may be, for example, Cu, Ni, or the like. The material of the metal bonding layer 313 may be the same as or different from the material of the metal bonding layer 317. However, in a case where the material of the metal bonding layer 313 is the same as the material of the metal bonding layer 317, the film thickness of the metal bonding layer 313 can be made smaller than the film thickness of the metal bonding layer 317. The surface layer 314 can ensure wettability of the solder material. The material of the surface layer 314 can be, for example, Au. The material and film thickness of the surface layer 314 may be the same as the material and film thickness of the surface layer 318.

In addition, on the substrate 111 outside the cavity 112, an insulating layer 315 is formed so as to cover the periphery of the barrier metal layer 312. The material of the insulating layer 315 can be, for example, aluminum oxide. The material and film thickness of the insulating layer 315 may be the same as the material and film thickness of the insulating layer 319.

The metal bonding layer 323 is formed on the cover 121. The metal bonding layer 323 may be formed in a line shape or a dot shape along the outer periphery of the cover 121. The metal bonding layer 323 can be bonded to the solder layer 124. The material of the metal bonding layer 323 may be, for example, Cu, Ni, Au, or the like, or may have a laminated structure of two or more of these metals.

Then, as illustrated in b of the drawing, the metal bonding layer 323 and the surface layer 314 are connected via the solder layer 124, whereby the package 300 in which the cover 121 is mounted on the substrate 111 is manufactured. At this time, before the cover 121 is mounted on the substrate 111, the solder layer 124 may be formed on the metal bonding layer 323, or the solder layer 124 may be formed on the surface layer 314, as illustrated in a of the drawing.

As illustrated in c of the drawing, the package 300 in which the cover 121 is mounted on the substrate 111 is mounted on the mother board 131 via the bump electrode 117. Then, when the mother board 131 on which the package 300 is mounted is incorporated into a product such as a camera, the cover 121 can be removed. When the cover 121 is removed, a solder alloy layer in which the metal included in the metal bonding layer 313 and the solder layer 124 are alloyed is generated. At this time, by allowing the solder alloy layer to reach the barrier metal layer 312, the solder alloy layer can be easily peeled off from the barrier metal layer 312. Therefore, the cover 121 can be removed from the substrate 111 at the boundary between the solder alloy layer and the barrier metal layer 312. At this time, the package 300' from which the cover 121 is removed is formed on the mother board 131. Here, since the solder alloy layer is removed from the package 300 together with the cover 121, the solder alloy layer does not remain in the package 300'.

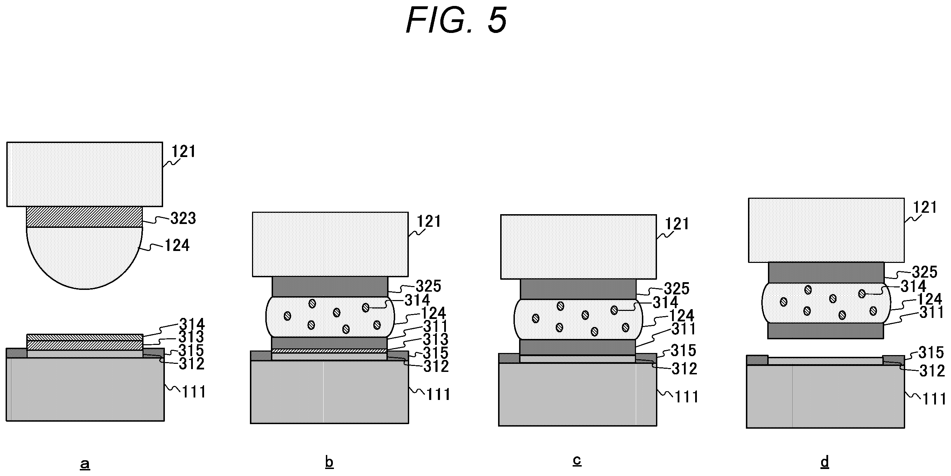

Fig. 5 is a cross-sectional view illustrating an example of the cover removal process according to the third embodiment. Note that, a in the drawing is a cross-sectional view illustrating an example of a state of the barrier metal layer 312 and the metal bonding layer 313 before the cover 121 is attached. b in the drawing is a cross-sectional view illustrating an example of a state of the barrier metal layer 312, the metal bonding layer 313, and the solder alloy layer 311 after the cover 121 is attached. c in the drawing is a cross-sectional view illustrating an example of a state in which the solder alloy layer 311 reaches the barrier metal layer 312 after the cover 121 is attached. d in the drawing is a cross-sectional view illustrating an example of a state of the barrier metal layer 312 and the solder alloy layer 311 after the cover 121 is removed.

In a of the drawing, the solder layer 124 is formed on the metal bonding layer 323. The cover 121 provided with the solder layer 124 is positioned such that the solder layer 124 and the surface layer 314 face each other.

Next, as illustrated in b of the drawing, the solder layer 124 provided on the cover 121 is bonded to the surface layer 314 on the basis of the heat treatment. At this time, The surface layer 314 diffuses into the solder layer 124. In addition, a solder alloy layer 325 in which the metal bonding layer 323 and the solder layer 124 are alloyed is generated. For example, in a case where the material of the solder layer 124 is Sn and the material of the metal bonding layer 323 is Cu, IMC of Sn and Cu is formed as the solder alloy layer 325. In addition, the metal included in the metal bonding layer 313 diffuses into the solder layer 124, and the solder alloy layer 311 in which the metal included in the metal bonding layer 313 and the solder layer 124 are alloyed is generated in a part of the metal bonding layer 313. For example, in a case where the material of the solder layer 124 is Sn and the material of the metal bonding layer 313 is Cu, IMC of Sn and Cu is formed as the solder alloy layer 311.

As illustrated in c of the drawing, the solder alloy layer 311 reaches the barrier metal layer 312 as the heat treatment proceeds, and can be peeled off from the barrier metal layer 312. Therefore, as illustrated in d in the drawing, the cover 121 can be removed from the substrate 111 at the boundary between the solder alloy layer 311 and the barrier metal layer 312.

As described above, in the third embodiment, the metal bonding layer 313 is formed on the substrate 111 via the barrier metal layer 312. Then, the solder alloy layer 311 obtained by alloying the solder layer 124 connecting the cover 121 and the substrate 111 with the metal bonding layer 313 reaches the barrier metal layer 312. As a result, the solder alloy layer 311 can be peeled off from the barrier metal layer 312, and the bonding force between the metal bonding layer 313 and the barrier metal layer 312 can be eliminated. Therefore, the cover 121 can be easily removed from the substrate 111 while the mountability of the cover 121 to the substrate 111 is stabilized.

### <4. Fourth Embodiment>

In the third embodiment described above, the barrier metal layer 312 and the metal bonding layer 313 are formed on the substrate 111. In a fourth embodiment, the barrier metal layer 312 and the metal bonding layer 313 are formed on the frame member 415 that separates the cover 121 from the semiconductor chip 101 mounted on the substrate 211.

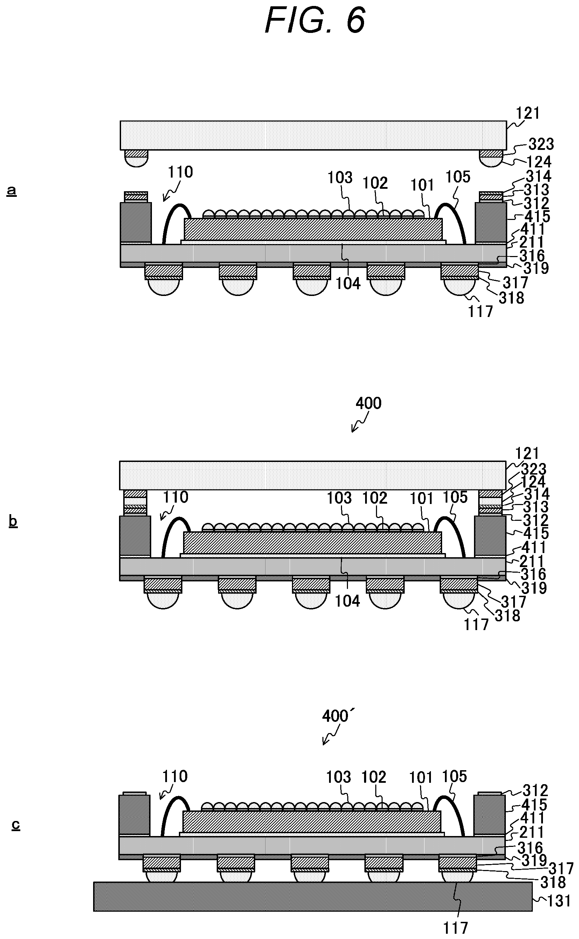

Fig. 6 is a cross-sectional view illustrating a configuration example of a package according to the fourth embodiment. Note that a in the drawing is a cross-sectional view illustrating a schematic configuration example of a frame member 415 before the cover 121 is attached. b in the drawing is a cross-sectional view illustrating a schematic configuration example of a package 400 in which the cover 121 is attached to the frame member 415. c in the drawing is a cross-sectional view illustrating a mounting example of a package 400' from which the cover 121 is removed.

In the drawing, the package 400 includes the substrate 211 instead of the substrate 111 of the above-described third embodiment. In addition, in the package 400, the frame member 415 is added to the package 300 of the above-described third embodiment. Other configurations of the package 400 of the fourth embodiment are similar to those of the package 300 of the third embodiment described above.

The frame member 415 separates the cover 121 from the semiconductor chip 101 mounted on the substrate 211. The frame member 415 can be configured in a frame shape so as to be located outside the bonding region. The frame member 415 is fixed on the substrate 211. An adhesive layer 411 may be used to fix the frame member 415 on the substrate 211. The material of the frame member 415 may be metal such as stainless steel or resin such as epoxy. The cover 121 can be fixed to the frame member 415 via the solder layer 124.

The metal bonding layer 313 is formed on the frame member 415 with the barrier metal layer 312 interposed therebetween. The surface layer 314 is formed on the metal bonding layer 313. At this time, the surface layer 314 is disposed at a position facing the metal bonding layer 323. Note that the frame member 415 is an example of a mounting portion described in the claims.

Then, as illustrated in b of the drawing, the metal bonding layer 323 and the surface layer 314 are connected via the solder layer 124, whereby the package 400 in which the cover 121 is mounted on the frame member 415 is manufactured. At this time, before the cover 121 is mounted on the frame member 415, the solder layer 124 may be formed on the metal bonding layer 323, or the solder layer 124 may be formed on the surface layer 314, as illustrated in a of the drawing.

As illustrated in c of the drawing, the package 400 in which the cover 121 is mounted on the substrate 211 is mounted on the mother board 131 via the bump electrode 117. Then, when the mother board 131 on which the package 400 is mounted is incorporated into a product such as a camera, the cover 121 can be removed. At this time, the package 400' from which the cover 121 is removed is formed on the mother board 131.

As described above, in the above-described fourth embodiment, the barrier metal layer 312 and the metal bonding layer 313 are formed on the frame member 415. As a result, it is possible to easily remove the cover 121 from the substrate 211 while stabilizing the mountability of the cover 121 on the substrate 211, and it is not necessary to form a cavity in the cover 121 and the substrate 211, and it is possible to prevent complication of the configurations of the cover 121 and the substrate 211.

### <5. Fifth Embodiment>

In the first embodiment described above, the barrier metal layer 122 and the metal bonding layer 123 are formed on the cover 121. In a fifth embodiment, a barrier metal layer and a metal bonding layer are formed on a semiconductor chip.

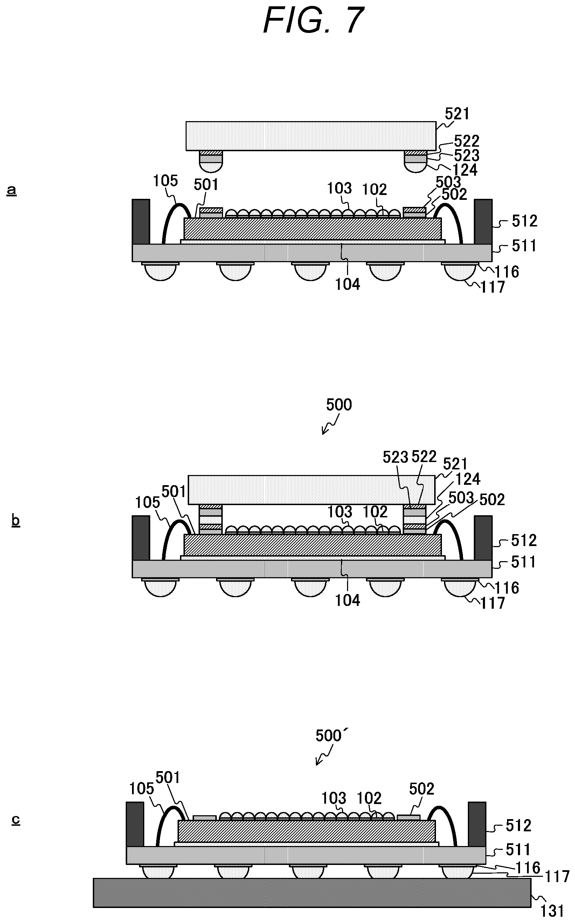

Fig. 7 is a cross-sectional view illustrating a configuration example of a package according to the fifth embodiment. Note that a in the drawing is a cross-sectional view illustrating a schematic configuration example of a semiconductor chip 501 before a cover 521 is attached. b in the drawing is a cross-sectional view illustrating a schematic configuration example of a package 500 in which the cover 521 is attached to the semiconductor chip 501. c in the drawing is a cross-sectional view illustrating a mounting example of a package 500' from which the cover 521 is removed.

In the drawing, the package 500 includes the semiconductor chip 501, the substrate 511, and the cover 521.

The substrate 511 can be formed in, for example, a flat plate shape. The bump electrode 117 is formed on the back surface of the substrate 511 via the land electrode 116. Wiring and bonding pads may be formed on the substrate 511. A partition 512 may be formed on the substrate 511 so as to be located outside the bonding region.

The semiconductor chip 501 is face-up mounted on the substrate 511. At this time, the semiconductor chip 501 is die-bonded onto the substrate 511 via the die-bonding material 104. On the semiconductor chip 501, the on-chip lens 103 may be formed for each pixel via the color filter 102. The semiconductor chip 501 is electrically connected to the substrate 511 via the bonding wire 105.

The cover 521 is disposed on the semiconductor chip 501 so as to be separated from the semiconductor chip 501. In order to prevent the cover 521 from contacting the bonding wire 105, the planar size of the cover 521 may be smaller than the planar size of the semiconductor chip 501. The cover 521 is fixed on the semiconductor chip 501 via the solder layer 124. At this time, the cover 521 may be insulated from the semiconductor chip 501. Note that the semiconductor chip 501 is an example of a mounting portion described in the claims.

Metal bonding layers 522 and 523 are formed on the cover 521. The metal bonding layers 522 and 523 may be formed in a line shape or a dot shape along the outer periphery of the cover 521. The metal bonding layers 522 and 523 can be bonded to the solder layer 124. As the material of the metal bonding layers 522 and 523, a metal capable of interdiffusing with the solder layer 124 can be used. The material of the metal bonding layers 522 and 523 may be, for example, Cu, Ni, Au, or the like.

On the semiconductor chip 501, the metal bonding layer 503 is formed via the barrier metal layer 502 so as to be located outside the pixel region of the semiconductor chip 501. At this time, in the semiconductor chip 501, a joining region where the barrier metal layer 502 and the metal bonding layer 503 are disposed can be provided between the pixel region and the bonding region. The barrier metal layer 502 and the metal bonding layer 503 may be formed in a line shape or a dot shape along the outer periphery of the semiconductor chip 501. The material of the barrier metal layer 502 can be a metal that allows the metal bonding layer 503 to be plated on the barrier metal layer 502 and does not interdiffuse with the solder layer 124. The material of the barrier metal layer 502 may be, for example, a metal such as Ti, Ta, or W, or may have a laminated structure of two or more of these metals. The metal bonding layer 503 can be bonded to the solder layer 124. Metal that can interdiffuse with the solder layer 124 can be used as the material of the metal bonding layer 503. The material of the metal bonding layer 503 may be, for example, Cu, Ni, Au, or the like, or may have a laminated structure of two or more of these metals.

Then, as illustrated in b of the drawing, the metal bonding layers 523 and 503 are connected via the solder layer 124, whereby the package 500 in which the cover 521 is mounted on the semiconductor chip 501 is manufactured. At this time, before the cover 521 is mounted on the semiconductor chip 501, the solder layer 124 may be formed on the metal bonding layer 523 or the solder layer 124 may be formed on the metal bonding layer 503 as illustrated in a of the drawing.

As illustrated in c of the drawing, the package 500 in which the cover 521 is mounted on the semiconductor chip 501 is mounted on the mother board 131 via the bump electrode 117. Then, when the mother board 131 on which the package 500 is mounted is incorporated into a product such as a camera, the cover 521 can be removed. When the cover 521 is removed, a solder alloy layer in which the metal included in the metal bonding layer 503 and the solder layer 124 are alloyed is generated. At this time, by allowing the solder alloy layer to reach the barrier metal layer 502, the solder alloy layer can be easily peeled off from the barrier metal layer 502. Therefore, the cover 521 can be removed from the semiconductor chip 501 at the boundary between the solder alloy layer and the barrier metal layer 502. At this time, the package 500' from which the cover 521 is removed is formed on the mother board 131. Here, since the solder alloy layer is removed from the package 500 together with the cover 521, the solder alloy layer does not remain in the package 500'.

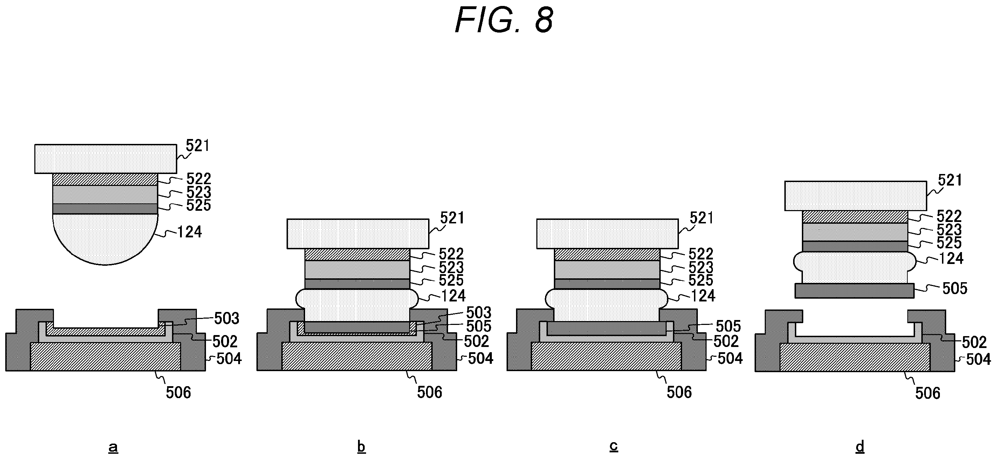

Fig. 8 is a cross-sectional view illustrating an example of the cover removal process according to the fifth embodiment. Note that, a in the drawing is a cross-sectional view illustrating an example of a state of the barrier metal layer 502 and the metal bonding layer 503 before the cover 521 is attached. b in the drawing is a cross-sectional view illustrating an example of a state of the barrier metal layer 502, the metal bonding layer 503, and the solder alloy layer 505 after the cover 521 is attached. c in the drawing is a cross-sectional view illustrating an example of a state in which the solder alloy layer 505 reaches the barrier metal layer 502 after the cover 521 is attached. d in the drawing is a cross-sectional view illustrating an example of a state of the barrier metal layer 502 and the solder alloy layer 505 after the cover 521 is removed.

In the drawing, a base layer 506 is formed on the semiconductor chip 501. The base layer 506 may be formed on the wiring layer. At this time, the barrier metal layer 502 can be formed on the base layer 506, and the metal bonding layer 503 can be formed on the barrier metal layer 502. An insulating layer 504 is formed around the base layer 506 so as to cover the end portions of the barrier metal layer 502 and the metal bonding layer 503. The material of the insulating layer 504 may be, for example, SiO₂ or SiN. The solder layer 124 is formed on the metal bonding layer 523. At this time, the solder alloy layer 525 in which the metal included in the metal bonding layer 523 and the solder layer 124 are alloyed is formed in a part of the metal bonding layer 523. For example, in a case where the material of the solder layer 124 is Sn and the material of the metal bonding layer 523 is Ni, IMC of Sn and Ni is formed as the solder alloy layer 525. The cover 521 provided with the solder layer 124 is positioned such that the solder layer 124 and the metal bonding layer 503 face each other.

Next, as illustrated in b of the drawing, the solder layer 124 provided on the cover 521 is bonded to the metal bonding layer 503 on the basis of the heat treatment. At this time, the solder alloy layer 505 in which the metal bonding layer 503 and the solder layer 124 are alloyed is generated in a part of the metal bonding layer 503. For example, in a case where the material of the solder layer 124 is Sn and the material of the metal bonding layer 503 is Cu, IMC of Sn and Cu is formed as the solder alloy layer 505.

As illustrated in c of the drawing, the solder alloy layer 505 reaches the barrier metal layer 502 as the heat treatment proceeds, and can be peeled off from the barrier metal layer 502. Therefore, as illustrated in d in the drawing, the cover 521 can be removed from the semiconductor chip 501 at the boundary between the solder alloy layer 505 and the barrier metal layer 502.

As described above, in the above-described fifth embodiment, the metal bonding layer 503 is formed on the semiconductor chip 501 via the barrier metal layer 502. Then, the solder alloy layer 505 obtained by alloying the solder layer 124 connecting the cover 521 and the substrate 511 with the metal bonding layer 503 reaches the barrier metal layer 502. As a result, the solder alloy layer 505 can be peeled off from the barrier metal layer 502, and the bonding force between the metal bonding layer 503 and the barrier metal layer 502 can be eliminated. Therefore, the cover 521 can be easily removed from the semiconductor chip 501 while the mountability of the cover 521 on the semiconductor chip 501 is stabilized.

### <6. Sixth Embodiment>

In the above-described fifth embodiment, the barrier metal layer 502 and the metal bonding layer 503 are formed on the front surface side of the semiconductor chip 501 to be face-up mounted. In a sixth embodiment, a barrier metal layer and a metal bonding layer are formed on the back surface side of a semiconductor chip to be face-down mounted.

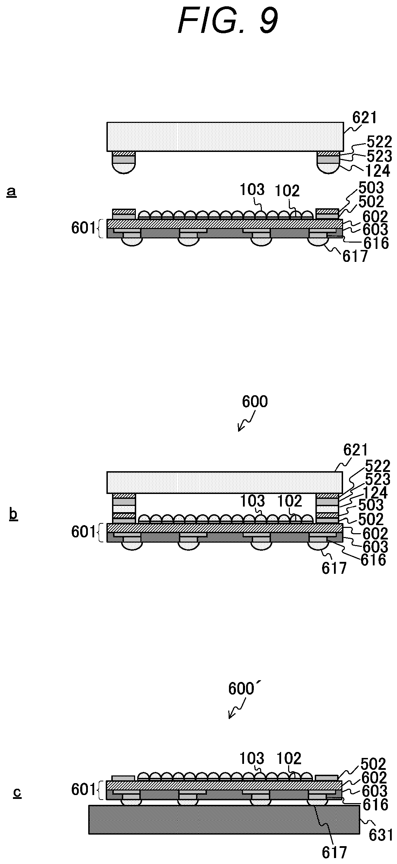

Fig. 9 is a cross-sectional view illustrating a configuration example of a package according to the sixth embodiment. Note that a in the drawing is a cross-sectional view illustrating a schematic configuration example of a semiconductor chip 601 before a cover 621 is attached. b in the drawing is a cross-sectional view illustrating a schematic configuration example of a package 600 in which the cover 621 is attached to the semiconductor chip 601. c in the drawing is a cross-sectional view illustrating a mounting example of a package 600' from which the cover 621 is removed.

In the drawing, the package 600 includes the semiconductor chip 601 and the cover 621. At this time, the package 600 may constitute a wafer level chip size package (WLCSP).

The semiconductor chip 601 includes a semiconductor layer 602 and a wiring layer 603. The wiring layer 603 is formed on the semiconductor layer 602. Wiring 616 is formed in the wiring layer 603. A bump electrode 617 connected to the wiring 616 is formed on the wiring layer 603.

On the back surface side of the semiconductor layer 602, a pixel region in which pixels are arranged in a matrix in the row direction and the column direction is provided. On the back surface of the semiconductor layer 602, the on-chip lens 103 may be formed for each pixel via the color filter 102.

In addition, on the back surface of the semiconductor layer 602, the metal bonding layer 503 is formed with the barrier metal layer 502 interposed therebetween so as to be located outside the pixel region of the semiconductor chip 501. At this time, on the back surface side of the semiconductor layer 602, a joining region where the barrier metal layer 502 and the metal bonding layer 503 are disposed can be provided outside the pixel region. The barrier metal layer 502 and the metal bonding layer 503 may be formed in a line shape or a dot shape along the outer periphery of the semiconductor chip 601.

The cover 621 is disposed on the back surface of the semiconductor chip 601 so as to be separated from the semiconductor chip 601. The cover 621 is fixed to the back surface side of the semiconductor chip 601 via the solder layer 124. The metal bonding layers 522 and 523 are formed on the cover 621. The metal bonding layers 522 and 523 may be formed in a line shape or a dot shape along the outer periphery of the cover 621. Note that the semiconductor chip 601 is an example of a mounting portion described in the claims.

Then, as illustrated in b of the drawing, by connecting the metal bonding layers 523 and 503 via the solder layer 124, the package 600 in which the cover 621 is mounted on the back surface side of the semiconductor chip 601 is manufactured. At this time, before the cover 621 is attached to the back surface side of the semiconductor chip 601, the solder layer 124 may be formed on the metal bonding layer 523, or the solder layer 124 may be formed on the metal bonding layer 503, as illustrated in a of the drawing.

Here, the planar size of the cover 621 can be equal to the planar size of the semiconductor chip 601. At this time, a transparent wafer having the same planar size as the semiconductor wafer can be laminated via the solder layer 124 on the semiconductor wafer in which the plurality of semiconductor chips 601 is integrated. Then, the semiconductor package 600 may be formed by singulating the laminated wafer by methods such as blade dicing.

As illustrated in c of the drawing, the package 600 in which the cover 621 is mounted on the back surface side of the semiconductor chip 601 is mounted on a mother board 631 via the bump electrode 117. Then, when the mother board 131 on which the package 600 is mounted is incorporated into a product such as a camera, the cover 621 can be removed. When the cover 621 is removed, a solder alloy layer in which the metal included in the metal bonding layer 503 and the solder layer 124 are alloyed is generated. At this time, by allowing the solder alloy layer to reach the barrier metal layer 502, the solder alloy layer can be easily peeled off from the barrier metal layer 502. Therefore, the cover 621 can be removed from the semiconductor chip 601 at the boundary between the solder alloy layer and the barrier metal layer 502. At this time, the package 600' from which the cover 621 is removed is formed on the mother board 131. Here, since the solder alloy layer is removed from the package 600 together with the cover 621, the solder alloy layer does not remain in the package 600'.

As described above, in the above-described sixth embodiment, the metal bonding layer 503 is formed on the back surface side of the semiconductor chip 601 to be face-down mounted via the barrier metal layer 502. This makes it possible to easily remove the cover 621 from the semiconductor chip 601 while stabilizing the mountability of the cover 621 on the semiconductor chip 601. In addition, it is not necessary to provide a bonding region in the semiconductor chip 601, and the chip size of the semiconductor chip 601 can be reduced.

Further, the semiconductor chip 601 can be packaged on the basis of the cover 621 having the same size as the semiconductor chip 601. Therefore, the cover 621 can be collectively arranged on the plurality of semiconductor chips 601 in a wafer state in which the plurality of semiconductor chips 601 is integrated, and the manufacturing efficiency of the package 600 can be improved.

### <7. Seventh Embodiment>

In the first embodiment described above, the metal bonding layer 123 is formed on the cover 121 via the barrier metal layer 122. In a seventh embodiment, the barrier metal layer 122 and the metal bonding layer 123 are patterned on the cover 121.

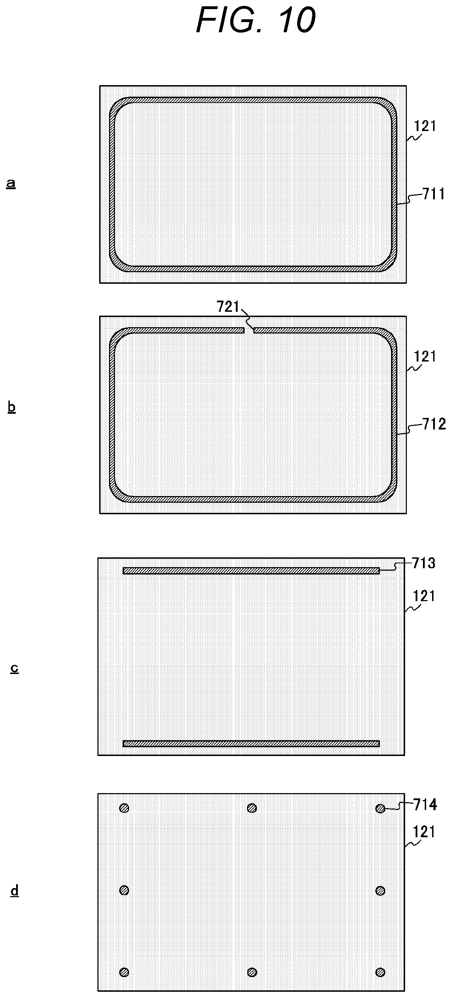

Fig. 10 is a plan view illustrating a configuration example of a cover according to the seventh embodiment. Note that a to d in the drawing respectively illustrate first to fourth examples of planar patterns of a barrier metal layer and a metal bonding layer formed on the cover 121.

In a of the drawing, a metal bonding layer 711 is continuously formed on the cover 121 in the peripheral portion along the outer periphery of the cover 121. A barrier metal layer can be formed under the metal bonding layer 711, and a solder layer can be formed on the metal bonding layer 711. The metal bonding layer 711 may be a rectangular pattern. The corners of the metal bonding layer 711 may have curvature. At this time, a round may be formed at a corner of the metal bonding layer 711.

As described above, in the first example of the seventh embodiment, a round is formed at the corner of the metal bonding layer 711 continuously formed along the outer periphery of the cover 121. As a result, the interior of the package to which the cover 121 is attached can be sealed, and entry of foreign matter such as dust and dirt can be prevented. In addition, by forming a round at the corner of the metal bonding layer 711, solder accumulation during solder reflow can be suppressed.

In b of the drawing, a metal bonding layer 712 is formed on the cover 121 in the peripheral portion along the outer periphery of the cover 121. In the metal bonding layer 712, an air hole 721 crossing the metal bonding layer 712 is formed. It is sufficient that one or more air holes 721 are provided in the metal bonding layer 712. The diameter of the air hole 721 is preferably as small as possible within a range in which clogging due to foreign matters such as dust and dirt can be prevented. A barrier metal layer can be formed under the metal bonding layer 712, and a solder layer can be formed on the metal bonding layer 712. The metal bonding layer 712 may be a rectangular pattern. The corners of the metal bonding layer 712 may have curvature. At this time, a round may be formed at a corner of the metal bonding layer 721.

As described above, in the second example of the seventh embodiment, the air hole 721 is formed in the metal bonding layer 712 formed along the outer periphery of the cover 121. As a result, it is possible to suppress an increase in pressure inside sealed by the cover 121 at the time of reflow of the package, and it is possible to prevent peeling and cracking of the semiconductor chip mounted in the package.

In c of the drawing, a metal bonding layer 713 is formed on the cover 121 along the side of the cover 121 in the peripheral portion. At this time, the metal bonding layer 713 may be formed along two opposing sides of the cover 121. A barrier metal layer can be formed under the metal bonding layer 713, and a solder layer can be formed on the metal bonding layer 713.

As described above, in the third example of the seventh embodiment, the metal bonding layer 713 is formed along two opposing sides of the cover 121. As a result, it is possible to fix the cover 121 to the package while making the cover 121 removable, and it is possible to suppress an increase in pressure inside sealed by the cover 121 at the time of reflow of the package.

In d of the drawing, the metal bonding layer 714 is discretely formed in a dot shape on the cover 121 so as to be adjacent to the side of the cover 121. A barrier metal layer can be formed under the metal bonding layer 714, and a solder layer can be formed on the metal bonding layer 714.

As described above, in the fourth example of the above-described seventh embodiment, the metal bonding layer 714 is discretely formed in a dot shape so as to be adjacent to the side of the cover 121. As a result, by adjusting the number and diameter of the metal bonding layers 714 discretely arranged in a dot shape, it is possible to easily adjust the external force necessary for removing the cover 121.

Note that, in the seventh embodiment described above, an example in which the barrier metal layer and the metal bonding layer are patterned on the cover 121 has been described. The planar patterns of the barrier metal layer and the metal bonding layer of the seventh embodiment described above may be applied to the cover 121 of the second embodiment described above, or may be applied to the substrate 111 of the third embodiment described above, in addition to the cover 221. In addition, the planar patterns of the barrier metal layer and the metal bonding layer of the seventh embodiment described above may be applied to the frame member 415 of the fourth embodiment described above. In addition, the planar patterns of the barrier metal layer and the metal bonding layer of the seventh embodiment described above may be applied to the semiconductor chip 501 of the fifth embodiment described above, or may be applied to the semiconductor chip 601 of the sixth embodiment described above.

### <8. Application Example to Mobile Body>

The technology according to the present disclosure (present technology) can be applied to various products. For example, the technology according to the present disclosure may be implemented as a device mounted on any type of mobile body such as an automobile, an electric vehicle, a hybrid electric vehicle, a motorcycle, a bicycle, a personal mobility, an airplane, a drone, a ship, and a robot.

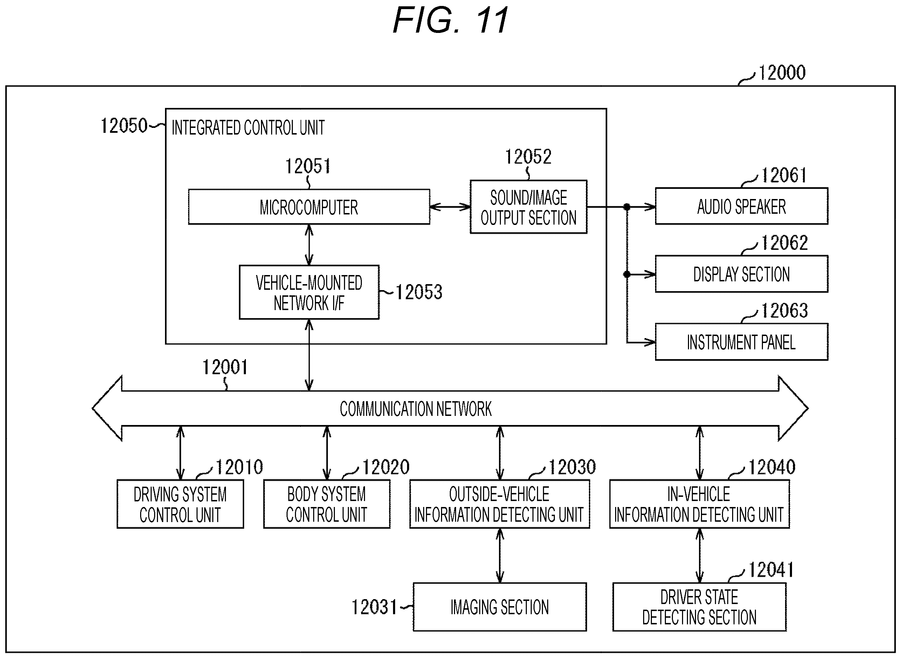

Fig. 11 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in Fig. 11, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 11, an audio speaker 12061, a display section 12062, and an instrument panel 12063 are illustrated as the output device. The display section 12062 may, for example, include at least one of an on-board display and a head-up display.

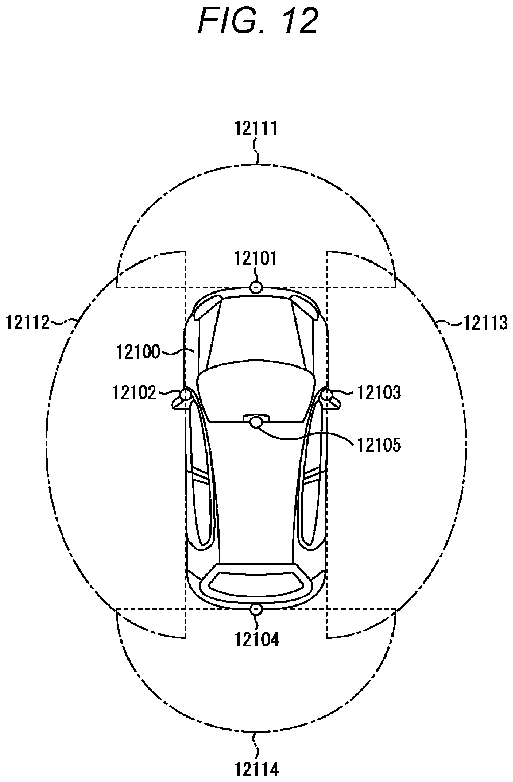

Fig. 12 is a diagram depicting an example of the installation position of the imaging section 12031.

In Fig. 12, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 12 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 among the configurations described above. Specifically, for example, the above-described packages 100' to 600' may be applied to the imaging section 12031 of the vehicle control system 12000. By applying the technology according to the present disclosure to the vehicle control system 12000, it is possible to obtain a captured image while suppressing the influence of flare.

Note that the above-described embodiments illustrate examples for embodying the present technology, and the matters in the embodiments and the matters specifying the invention in the claims have a correspondence relationship. Similarly, the matters specifying the invention in the claims and the matters in the embodiments of the present technology denoted by the same names as the matters specifying the invention have a correspondence relationship. However, the present technology is not limited to the embodiments, and can be embodied by making various modifications to the embodiments without departing from the gist thereof. Furthermore, the effects described in the present specification are merely examples and are not limited, and other effects may be provided.

Note that the present technology can also have the following configurations.
(1) A package including:
   a cover;
   a mounting portion to which the cover is mounted;
   a barrier metal layer provided between the cover and the mounting portion;
   a metal bonding layer formed on the barrier metal layer; and
   a solder layer that is bonded to the metal bonding layer and connects the cover and the mounting portion.
(2) The package according to (1), in which
   the barrier metal layer is formed on the cover.
(3) The package according to (1), in which
   the barrier metal layer is formed on the mounting portion.
(4) The package according to (1), further including
   a substrate on which the mounting portion is provided, in which the barrier metal layer is formed on the substrate.
(5) The package according to (5), in which
   the cover is insulated from the substrate.
(6) The package according to (4) or (5), further including a semiconductor chip mounted on the substrate.
(7) The package according to any one of (4) to (6), in which
   the substrate includes a cavity in which the semiconductor chip is accommodated, and
   the mounting portion is disposed around the cavity.
(8) The package according to any one of (4) to (7), in which
   a light receiving element or a light emitting element is formed on the semiconductor chip.
(9) The package according to (1), further including
   a semiconductor chip on which the mounting portion is provided, in which
   the barrier metal layer is formed on the semiconductor chip.
(10) The package according to (9), in which
   the cover is insulated from the semiconductor chip.
(11) The package according to any one of (1) to (10), further including
   a land electrode connected to an outside on the basis of solder connection, in which
   the land electrode includes a land electrode that is bonded to solder and is different in material or film thickness from the metal bonding layer.
(12) The package according to any one of (1) to (11), in which the cover is transparent.
(13) The package according to any one of (1) to (12), in which
   the barrier metal layer does not interdiffuse with the solder layer.
(14) The package according to any one of (1) to (13), in which a film thickness of the metal bonding layer is 1 µm or less.
(15) The package according to any one of (1) to (14), in which
   an area of the metal bonding layer is smaller than a connection area on an opposite side of the solder layer bonded to the metal bonding layer.
(16) A method for manufacturing a package, the method including:
   a step of causing a solder alloy layer in which a metal included in a metal bonding layer and a solder layer are alloyed to reach a barrier metal layer by heat-treating the package in which a cover is mounted on a mounting portion via the solder layer bonded to the metal bonding layer formed on the barrier metal layer; and
   a step of peeling the cover from the mounting portion at a boundary between the solder alloy layer and the barrier metal layer.
(17) The method for manufacturing the package according to (16), in which
   the barrier metal layer is formed on the cover.
(18) The method for manufacturing the package according to (16), in which
   the barrier metal layer is formed on the mounting portion.
(19) The method for manufacturing the package according to (16), in which
   the mounting portion is provided on a substrate, and the barrier metal layer is formed on the substrate.
(20) The method for manufacturing the package according to (16), in which
   the mounting portion is provided on a semiconductor chip, and the barrier metal layer is formed on the semiconductor chip.

### REFERENCE SIGNS LIST

- 100: Package
- 111: Substrate
- 112: Cavity
- 113: Base layer
- 114: Intermediate layer
- 115: Surface layer
- 116: Land electrode
- 117: Bump electrode
- 101: Semiconductor chip
- 102: Color filter
- 103: On-chip lens
- 104: Die-bonding material
- 105: Bonding wire
- 121: Cover
- 122: Barrier metal layer
- 123: Metal bonding layer
- 124: Solder layer
- 125: Solder alloy layer
- 131: Mother board

## Claims

1. A package comprising:
a cover;
a mounting portion to which the cover is mounted;
a barrier metal layer provided between the cover and the mounting portion;
a metal bonding layer formed on the barrier metal layer; and
a solder layer that is bonded to the metal bonding layer and connects the cover and the mounting portion.

2. The package according to claim 1, wherein
the barrier metal layer is formed on the cover.

3. The package according to claim 1, wherein
the barrier metal layer is formed on the mounting portion.

4. The package according to claim 1, further comprising
a substrate on which the mounting portion is provided, wherein
the barrier metal layer is formed on the substrate.

5. The package according to claim 4, wherein
the cover is insulated from the substrate.

6. The package according to claim 4, further comprising a semiconductor chip mounted on the substrate.

7. The package according to claim 6, wherein
the substrate includes a cavity in which the semiconductor chip is accommodated, and
the mounting portion is disposed around the cavity.

8. The package according to claim 7, wherein
a light receiving element or a light emitting element is formed on the semiconductor chip.

9. The package according to claim 1, further comprising
a semiconductor chip on which the mounting portion is provided, wherein
the barrier metal layer is formed on the semiconductor chip.

10. The package according to claim 9, wherein
the cover is insulated from the semiconductor chip.

11. The package according to claim 1, further comprising
a land electrode connected to an outside on a basis of solder connection, the land electrode being different in material or film thickness from the metal bonding layer.

12. The package according to claim 1, wherein
the cover is transparent.

13. The package according to claim 1, wherein
the barrier metal layer does not interdiffuse with the solder layer.

14. The package according to claim 1, wherein
a film thickness of the metal bonding layer is 1 µm or less.

15. The package according to claim 1, wherein
an area of the metal bonding layer is smaller than a connection area on an opposite side of the solder layer bonded to the metal bonding layer.

16. A method for manufacturing a package, the method comprising:
a step of causing a solder alloy layer in which a metal included in a metal bonding layer and a solder layer are alloyed to reach a barrier metal layer by heat-treating the package in which a cover is mounted on a mounting portion via the solder layer bonded to the metal bonding layer formed on the barrier metal layer; and
a step of peeling the cover from the mounting portion at a boundary between the solder alloy layer and the barrier metal layer.

17. The method for manufacturing the package according to claim 16, wherein
the barrier metal layer is formed on the cover.

18. The method for manufacturing the package according to claim 16, wherein
the barrier metal layer is formed on the mounting portion.

19. The method for manufacturing the package according to claim 16,
wherein
the mounting portion is provided on a substrate, and the barrier metal layer is formed on the substrate.

20. The method for manufacturing the package according to claim 16, wherein
the mounting portion is provided on a semiconductor chip, and the barrier metal layer is formed on the semiconductor chip.
